Europäisches Patentamt

European Patent Office

Office européen des brevets

(19)

(11) Numéro de publication : **0 060 744**
**B1**

(12) **FASCICULE DE BREVET EUROPÉEN**

(45) Date de publication du fascicule du brevet :
26.09.84

(51) Int. Cl.³ : **C 30 B 13/02, C 30 B 29/48**

(21) Numéro de dépôt : 82400310.7

(22) Date de dépôt : 22.02.82

(54) **Procédé de préparation de cristaux de $Hg_{1-x}Cd_xTe$.**

(30) Priorité : 18.03.81 FR 8105387

(43) Date de publication de la demande :
22.09.82 Bulletin 82/38

(45) Mention de la délivrance du brevet :
26.09.84 Bulletin 84/39

(84) Etats contractants désignés :
DE GB NL

(56) Documents cités :
FR-A- 2 295 792
GB-A- 2 051 607
IEEE TRANSACTIONS ON MAGNETICS, volume mag-5, no. 3, septembre 1969 US T. AKASHI: "Preparation of Ferrite Single Crystals by New Floating Zone Technique", pages 285 à 289
REVUE DE PHYSIQUE APPLIQUEE, tome 12, février 1977 FR R. TRIBOULET : "CdTe and CdTe: Hg alloys crystal growth using stiochiometric and off-stiochiometric zone passing techniques", pages 123 à 128

(73) Titulaire : **SOCIETE ANONYME DE TELECOMMUNICATIONS**
**40 avenue de New York**
**F-75116 Paris (FR)**

(72) Inventeur : **Triboulet, Robert Georges Lucien**
**26, rue de Terre Neuve**
**F-92190 Meudon (FR)**
Inventeur : **Didier, Gérard Emile Joseph**
**32, avenue du Maréchal de Tassigny**
**F-92360 Meudon La Foret (FR)**
Inventeur : **Durand, Alain René Lucien**
**29, Résidence des Tilleuls Rue de Vouneuil**
**F-86000 Poitiers (FR)**
Inventeur : **Royer, Michel**
**29, rue Claude Decaen**
**F-75012 Paris (FR)**

(74) Mandataire : **Bloch, Robert et al**
**39 avenue de Friedland**
**F-75008 Paris (FR)**

EP 0 060 744 B1

Jouve, 18, rue St-Denis, 75001 Paris, France

## Description

L'invention concerne un procédé de préparation de cristaux de $Hg_{1-x}Cd_xTe$ de haute pureté selon la technique dite THM (Travelling Heater Method) consistant à faire traverser une zone de solvant par des lingots de HgTe et de CdTe.

Le composé ternaire $Hg_{1-x}Cd_xTe$ est un semi-conducteur dont la largeur de bande interdite varie avec la proportion x de cadmium. Suivant la proportion x choisie, on peut obtenir des photo-détecteurs dont la sensibilité spectrale se situe dans différents domaines de l'infrarouge (autour de 1,5 $\mu$m pour x $\simeq$ 0,7, autour de 10 $\mu$m pour x $\simeq$ 0,20).

L'article de R. Triboulet « CdTe and CdTe : Hg alloys cristals growth using stoichiometric and off-stoichiometric zone passing techniques », paru dans la Revue de Physique Appliquée, tome 12, février 1977, page 123, décrit la préparation de cristaux de $Hg_{1-x}Cd_xTe$, avec x $\simeq$ 0,9 à partir d'un lingot de HgTe et d'un lingot de CdTe, à l'aide de tellure comme solvant. Les deux lingots-sources se déplacent à vitesse très lente par rapport à la zone de solvant chauffée de façon appropriée. La partie des lingots-sources qui pénètre dans la zone de solvant se dissout et il se forme à la sortie de cette zone un cristal unique de $Hg_{x-1}Cd_xTe$, la proportion x de cadmium étant fonction du rapport entre les sections des lingots-sources.

On constate, à la lecture de l'article précité, que la composition du lingot de $Hg_{1-x}Cd_xTe$ obtenu n'est pas constante sur toute sa longueur. On observe en effet que la tête du lingot présente une proportion de cadmium plus importante que la valeur x désirée, et que de ce fait la proportion x désirée n'est obtenue que sur une partie du lingot, représentant environ 60 à 70 % de sa longueur.

Le problème posé consiste par conséquent à éliminer cette variation indésirable de la composition à la tête du lingot, de façon que pratiquement la totalité du lingot présente la composition et donc la sensibilité spectrale voulue.

On a découvert que cette variation de la composition était imputable au fait que le solvant, composé uniquement de tellure au début du processus, s'enrichit initialement en CdTe et HgTe dans un rapport égal à celui des sections des lingots-sources, correspondant à une proportion $x_L$ de CdTe, mais que le lingot qui se forme alors à la sortie de la zone de solvant présente une proportion $x_S$ de cadmium, déterminée par le diagramme de phases, qui est supérieure à $x_L$.

Du fait de cette différence entre $x_L$ et $x_S$, le prélèvement de CdTe dans la zone de solvant est plus important que l'apport de CdTe et progressivement, la zone de solvant s'appauvrit en cadmium et inversement s'enrichit en mercure. Ceci s'accompagne d'une réduction concomitante de la différence entre $x_L$ et $x_S$ et on arrive finalement à un état d'équilibre thermodynamique dans lequel le lingot formé présente une proportion $x_S$ égale à la proportion $x_L$ désirée correspondant au rapport des sections des lingots-sources, et la zone de solvant contient, en plus du tellure, des teneurs déterminées de CdTe et HgTe.

A partir de cette découverte, l'invention prévoit d'utiliser en tant que solvant, au lieu de tellure pur, un solvant composé de tellure, de tellurure de mercure HgTe et de tellurure de cadmium CdTe dans des proportions correspondant à l'équilibre thermodynamique précité.

Comme la composition du solvant est dès le départ à la valeur d'équilibre, le lingot formé présente dès le départ une proportion $x_S$ de cadmium sensiblement égale à la proportion désirée, de sorte que le lingot obtenu est utilisable sur toute sa longueur.

La composition d'équilibre, pour une valeur x donnée, ne dépend que des données thermodynamiques correspondant à la température du solvant, laquelle est elle-même choisie en fonction de x.

A titre d'exemple, pour une proportion de cadmium x = 0,7, avec une température de 700 °C, les proportions seront les suivantes :

| Te | 68 mol.-% |
|------|-----------|
| CdTe | 2 mol.-% |
| HgTe | 30 mol.-% |

L'invention sera bien comprise à la lecture de la description faite ci-après en liaison avec les dessins annexés.

Dans les dessins :

La figure 1   illustre schématiquement la préparation d'un lingot $Hg_{x-1}Cd_xTe$ par la technique THM.

La figure 2   montre le profil de composition du lingot obtenu selon l'invention, comparé au résultat du procédé classique.

La figure 3   illustre la préparation de la zone de solvant.

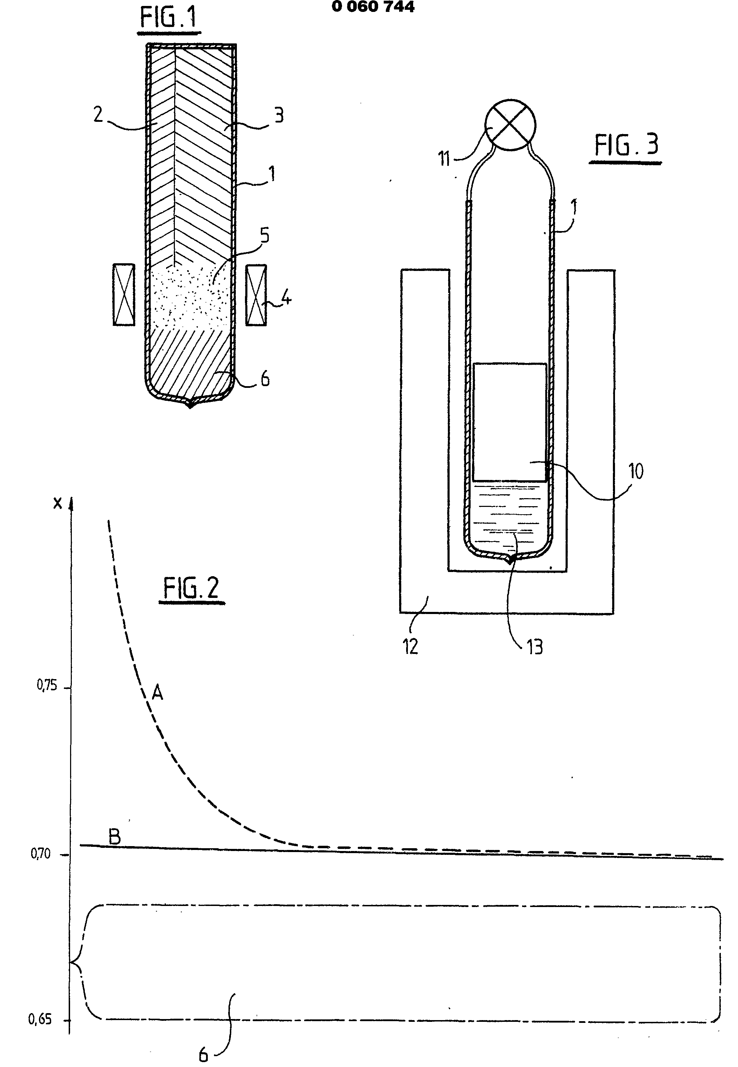

La figure 1   montre une enceinte 1 en matière réfractaire hermétiquement fermée, à l'intérieur de laquelle on a placé un lingot de HgTe 2 et un lingot de CdTe 3 de même longueur. La forme en section de ces lingots a peu d'importance pourvu que le rapport de leurs sections soit égal au rapport souhaité cadmium/mercure dans le produit final. Il s'agit par exemple de portions de cylindre.

Un dispositif de chauffage annulaire 4 constitué par un enroulement conducteur entoure l'enceinte 1 et se déplace suivant l'axe de celle-ci à une vitesse de l'ordre de 1 à 5 mm par jour, les moyens de déplacement pouvant être quelconques.

A l'intérieur de l'enceinte se trouve un mélange de tellure, de HgTe et de CdTe qui est liquide à la température de chauffage et qui joue le rôle de solvant pour les lingots de HgTe et CdTe. La zone de solvant résultante 5 est limitée à la portion chauffée par le dispositif 4 et se déplace d'une extrémité à l'autre des lingots du fait du déplacement du dispositif de chauffage.

La partie des lingots 2 et 3 qui entre en contact avec la zone de solvant 5 s'y dissout et se recristallise à la sortie de la zone 5 sous la forme d'un lingot unique 6 de $Hg_{1-x}Cd_xTe$ de haute pureté, dans lequel le rapport des proportions de mercure et de cadmium correspond au rapport des sections des lingots de HgTe et de CdTe 2 et 3.

La température T dans la zone de solvant est comprise entre 600 et 700 °C, la valeur exacte dépendant de la valeur x souhaitée. Pour x = 0,7, on applique de préférence une température T de 700 °C.

Pour x = 0,7 et T = 700 °C, on utilise un solvant de composition suivante :

| Te | 68 mol.-% |
| CdTe | 2 mol.-% |
| HgTe | 30 mol.-% |

La composition du mélange solvant correspond à la composition d'équilibre résultant des données thermodynamiques à la température T.

La figure 2 donne le profil de composition du lingot de $Hg_{x-1}Cd_xTe$ obtenu dans le cas où x = 0,7, lorsqu'on utilise comme solvant du tellure pur (courbe A en trait pointillé) et lorsqu'on utilise comme solvant le mélange selon l'invention défini ci-dessus (courbe B en trait plein).

On voit qu'avec le solvant de tellure, le lingot présente à sa tête (extrémité gauche des courbes) une proportion de cadmium supérieure à 0,7, et que la partie du lingot dans laquelle cette valeur est sensiblement respectée représente environ 70 % de la longueur du lingot.

Au contraire, avec le mélange selon l'invention, la composition est homogène et correspond à la valeur x = 0,7 sur la quasi-totalité de la longueur du lingot.

La préparation de la zone de solvant est illustrée par la fig. 3 et se fait de la façon suivante.

On commence par placer au fond de l'enceinte 1 du tellure, du tellurure de cadmium CdTe et du tellurure de mercure HgTe dans les proportions voulues. Ces produits sont à l'état solide et se trouvent sous forme de morceaux.

Par dessus ces produits, on place un piston de quartz 10 qui a pour rôle d'assurer une surface parfaitement plane de la zone de solvant.

On relie l'enceinte à une source de vide par la vanne 11, on fait le vide et on introduit un gaz neutre tel que l'argon à l'intérieur de l'enceinte, jusqu'à une pression d'environ 2 à 3 atmosphères (202 650 à 303 975 Pa), pour empêcher la décomposition du HgTe lors du chauffage.

On fait fondre ensuite les produits placés au fond de l'enceinte par chauffage dans un four 12. Le piston 10 flotte sur le mélange fondu formé 13 compte tenu de ce que sa densité est inférieure à celle du mélange fondu. Après 2 à 3 heures, on arrête le chauffage et le mélange se cristallise. Grâce à la présence du piston 10, la surface libre est restée parfaitement plane.

En l'absence du piston 10, la surface libre du liquide ne serait pas parfaitement plane à cause du caractère peu mouillant du mélange Te + HgTe + CdTe fondu et lors de la dissolution des lingots-sources 2 et 3 dans la zone de solvant, la progression ne serait pas la même sur toute la section de l'enceinte.

Après la cristallisation, on ouvre l'enceinte, on retire le piston 10 et on introduit les lingots-sources 2 et 3, après quoi le processus décrit plus haut peut commencer.

## Revendications

1. Procédé de préparation de cristaux de $Hg_{1-x}Cd_xTe$, dans lequel on fait traverser une zone de solvant par des lingots de HgTe et de CdTe, caractérisé par le fait qu'on utilise comme solvant un mélange de tellure, de HgTe et de CdTe en proportions correspondant à l'équilibre thermodynamique.

2. Procédé selon la revendication 1, caractérisé par le fait que, dans le cas où x = 0,7, le solvant est composé de 68 mol.-% de tellure, 30 mol.-% de HgTe et 2 mol.-% de CdTe.

3. Procédé selon la revendication 1, caractérisé par le fait que le mélange solvant est préparé en faisant fondre dans une enceinte fermée les constituants de départ solides, lesquels constituants sont surmontés par un piston dont la densité est inférieure à celle du mélange fondu.

4. Procédé selon la revendication 3, caractérisé par le fait que la fusion des constituants de départ se fait en atmosphère de gaz neutre.

## Claims

1. Process for preparing crystals of $Hg_{1-x}Cd_xTe$, in which lingots of HgTe and of CdTe are made to pass through a solvent zone, characterized in that is comprises the step of using as solvent a mixture of tellurium, of HgTe and CdTe in proportions corresponding to the thermodynamic balance.

2. The process of Claim 1, wherein, in the case of x = 0.7, the solvent is composed of 68 % mol of tellurium, 30 % mol of HgTe and 2 % mol of CdTe.

3. The process of Claim 1, wherein the solvent mixture is prepared by melting the solid starting constituents in a closed enclosure, which constituents are surmounted by a piston of which the density is lower than that of the molten mixture.

4. The process of Claim 3, wherein the starting constituents are melted in an atmosphere of neutral gas.

## Ansprüche

1. Verfahren zur Herstellung von Kristallen aus $Hg_{1-x}Cd_xTe$, bei dem man Blöcke aus HgTe und aus CdTe eine Lösungsmittelzone passieren läßt, dadurch gekennzeichnet, daß man als Lösungsmittel eine Mischung aus Tellur, aus HgTe und aus CdTe in den dem thermodynamischen Gleichgewicht entsprechenden Anteilen verwendet.

2. Verfahren nach Anspruch 1, dadurch gekennzeichnet, daß, im Fall dass x = 0,7, das Lösungsmittel aus 68 Mol.-% Tellur, 30 Mol.-% HgTe und 2 Mol.-% CdTe besteht.

3. Verfahren nach Anspruch 1, dadurch gekennzeichnet, daß man die Lösungsmittelmischung in der Weise herstellt, daß man in einem geschlossenen Behälter die festen Ausgangskomponenten schmilzt, die mit einem Kolben abgedeckt sind, dessen Massendichte kleiner ist als die der geschmolzenen Mischung.

4. Verfahren nach Anspruch 3, dadurch gekennzeichnet, daß man die Ausgangskomponenten in einer neutralen Gasatmosphäre schmilzt.

FIG.1

FIG.3

FIG.2